# EUROPEAN PATENT APPLICATION

(11) **EP 4 848 965 A1**
(43) Date of publication of application: **02.12.2026**
(21) Application number: 25894688.8
(22) Date of filing: 29.08.2025
(51) Int. Cl.: H10N 60/10, G06N 10/40

(54) **COMPUTING DEVICE**

(30) Priority: 19.11.2024 JP 2024201595
(71) Applicant: KABUSHIKI KAISHA TOSHIBA, Kawasaki-shi, Kanagawa 212-0013 (JP)
(72) Inventor: HO, Yinghao, Kawasaki-shi, Kanagawa 212-0013 (JP); KUBO, Kentaro, Kawasaki-shi, Kanagawa 212-0013 (JP); GOTO, Hayato, Kawasaki-shi, Kanagawa 212-0013 (JP)
(74) Representative: Marks & Clerk LLP
(86) International application number: PCT/JP2025/030560
(87) International publication number: WO 2026/110442

(57) **Abstract**

There is provided a computing device capable of obtaining stable characteristics. According to one embodiment, a computing device includes first to third structures. The first structure includes a first base, a first qubit fixed to the first base, a first circuit fixed to the first base and including a first Josephson junction, and a first conductive member. The first circuit includes a first circuit portion and a first other circuit portion. The first circuit portion is coupled with the first qubit. The first conductive member is electrically connected with the first other circuit portion. The second structure includes a second base, a second qubit fixed to the second base, and a second conductive member fixed to the first base and coupled with the second qubit. The third structure includes a third base, and a third conductive member fixed to the third base and including a first conductive portion and a second conductive portion. The first conductive portion is coupled with the first conductive member. The second conductive portion is coupled with the second conductive member.

## Description

### [Technical Field]

Embodiments described herein relate to a computing device.

### [Background Art]

For example, electronic circuits including a plurality of nonlinear elements are used in computing devices. In computing devices, stable characteristics are desired.

### [Prior Art Documents]

### [Patent Literature]

[Patent Literature 1] JP2023-20041A

### [Summary of Invention]

### [Problem to be Solved by the Invention]

Embodiments provide a computing device capable of obtaining stable characteristics.

### [Means for Solving the Problem]

According to one embodiment, a computing device includes an element part. The element part includes a first structure, a second structure, and a third structure. The first structure includes a first base, a first qubit fixed to the first base, a first circuit fixed to the first base and including a first Josephson junction, and a first conductive member. The first circuit includes a first circuit portion and a first other circuit portion. The first circuit portion is configured to be coupled with the first qubit. The first conductive member is electrically connected with the first other circuit portion. The second structure includes a second base, a second qubit fixed to the second base, and a second conductive member fixed to the first base and configured to be coupled with the second qubit. The third structure includes a third base, and a third conductive member fixed to the third base, the third conductive member including a first conductive portion and a second conductive portion. The first conductive portion is configured to be coupled with the first conductive member. The second conductive portion is configured to be coupled with the second conductive member.

### [Brief Description of Drawings]

[FIG. 1] FIG. 1 is a schematic diagram illustrating a computing device according to a first embodiment.
[FIG. 2] FIG. 2 is a schematic plan view illustrating the computing device according to the first embodiment.
[FIG. 3] FIGS. 3A and 3B are schematic plan views illustrating the computing device according to the first embodiment.
[FIG. 4] FIGS. 4A to 4C are schematic cross-sectional views illustrating the computing device according to the first embodiment.
[FIG. 5] FIG. 5 is a schematic diagram illustrating a computing device according to the first embodiment.
[FIG. 6] FIG. 6 is a schematic plan view illustrating a computing device according to the first embodiment.
[FIG. 7] FIGS. 7A and 7B are schematic plan views illustrating the computing device according to the first embodiment.
[FIG. 8] FIGS. 8A to 8C are schematic cross-sectional views illustrating the computing device according to the first embodiment.
[FIG. 9] FIG. 9 is a schematic diagram illustrating a computing device according to a second embodiment.
[FIG. 10] FIGS. 10A and 10B are schematic views illustrating a computing device according to a third embodiment.
[FIG. 11] FIGS. 11A and 11B are schematic views illustrating a computing device according to the third embodiment.
[FIG. 12] FIGS. 12A and 12B are schematic views illustrating a computing device according to the third embodiment.
[FIG. 13] FIGS. 13A and 13B are schematic views illustrating a computing device according to the third embodiment.
[FIG. 14] FIG. 14 is a schematic diagram illustrating the characteristics of a computing device according to the embodiment.
[FIG. 15] FIGS. 15A and 15B are graphs illustrating the characteristics of the electronic circuit according to the embodiment.

### [Description of Embodiments]

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### (First Embodiment)

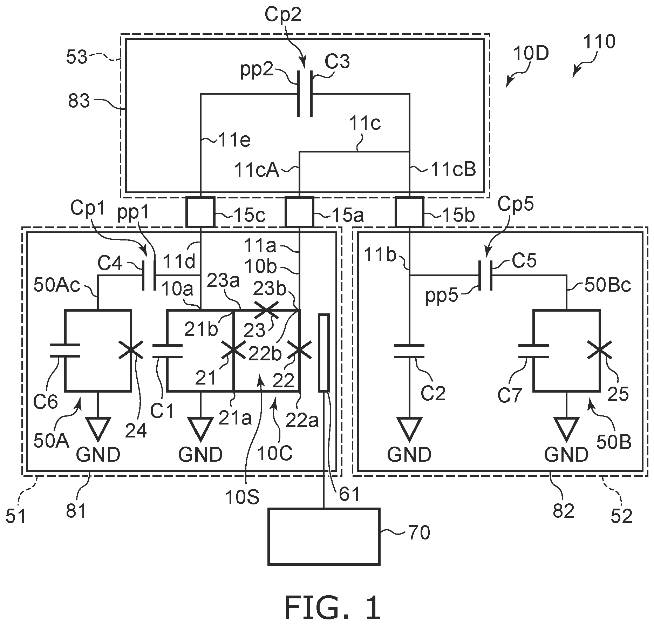

FIG. 1 is a schematic diagram illustrating a computing device according to the first embodiment.

As shown in FIG. 1, a computing device 110 according to the embodiment includes an element portion 10D. The element portion 10D includes a first structure 51, a second structure 52, and a third structure 53.

The first structure 51 includes a first base 81, a first qubit 50A, a first circuit 10C, and a first conductive member 11a. The first qubit 50A is fixed to the first base 81. The first circuit 10C is fixed to the first base 81. The first circuit 10C includes a first Josephson junction 21. As described below, the first circuit 10C may further include another Josephson junction.

The first circuit 10C includes a first circuit portion 10a and a first other circuit portion 10b. The first circuit portion 10a is configured to be coupled with the first qubit 50A. In the embodiment, "coupling" may include at least one of capacitive coupling or inductive coupling.

The first conductive member 11a is electrically connected with the first other circuit portion 10b.

The second structure 52 includes a second base 82, a second qubit 50B, and a second conductive member 11b. The second qubit 50B is fixed to the second base 82. The second conductive member 11b is fixed to the second base 82. The second conductive member 11b is configured to be coupled with the second qubit 50B.

The third structure 53 includes a third base 83 and a third conductive member 11c. The third conductive member 11c is fixed to the third base 83. The third conductive member 11c includes a first conductive portion 11cA and a second conductive portion 11cB. The first conductive portion 11cA is configured to be coupled with the first conductive member 11a. The second conductive portion 11cB is configured to be coupled with the second conductive member 11b.

In this example, the first conductive portion 11cA is coupled with the first conductive member 11a via the first connecting member 15a. The second conductive portion 11cB is coupled with the second conductive member 11b via the second connecting member 15b. The first conductive portion 11cA may be electrically connected with the first conductive member 11a via the first connecting member 15a. The second conductive portion 11cB may be electrically connected with the second conductive member 11b via a second connecting member 15b.

In the embodiment, the first circuit 10C including a Josephson junction is provided on the first base 81 including the first qubit 50A. On the other hand, the second base 82 including the second qubit 50B may not be provided with any Josephson junctions other than the second qubit 50B. The third base 83 may not be provided with any Josephson junctions.

For example, it is practically difficult to manufacture Josephson junctions with high productivity. For example, a reference example is considered in which the first qubit 50A, the first circuit 10C, and the second qubit 50B are formed on one base. In the reference example, the number of Josephson junctions on one base is large. When it is difficult to obtain good characteristics for all of the plurality of Josephson junctions, it is practically difficult to obtain a computing device with good characteristics with high productivity in the reference example.

In the embodiment, the first base 81 is provided with the first qubit 50A and the first circuit 10C including a Josephson junction. The second base 82 is provided with the second qubit 50B. The third base 83 is not provided with a Josephson junction. This makes it easier to manufacture the third base 83. The third base 83 only needs to be provided with a conductive member that connects the first structure 51 to the second structure 52. In this way, different bases are applied depending on the number of Josephson junctions. The elements included in the computing device are provided separately in plurality of structures, and the plurality of structures are combined. This makes it easy to stably obtain high performance. For example, it is easy to obtain a high manufacturing yield. For example, a large-scale quantum computer can be easily obtained. According to the embodiment, it is possible to provide a computing device that can obtain stable characteristics even when the scale is increased. In the embodiment, parasitic capacitance can be reduced. For example, it is easy to obtain a high degree of integration.

As shown in FIG. 1, in this example, the first circuit 10C further includes a second Josephson junction 22 and a third Josephson junction 23 in addition to the first Josephson junction 21. The second Josephson junction 22 is fixed to the first base 81. The third Josephson junction 23 is fixed to the first base 81.

The first Josephson junction 21 includes a first end 21a and a first other end 21b. The first other end 21b corresponds to the first circuit portion 10a. The second Josephson junction 22 includes a second end 22a and a second other end 22b. The second other end 22b corresponds to the first other circuit portion 10b. The second end 22a is electrically connected with the first end 21a. The third Josephson junction 23 includes a third end 23a and a third other end 23b. The third end 23a is electrically connected with the first other end 21b. The third other end 23b is electrically connected with the second other end 22b.

As described below, a magnetic flux passing through a space 10S surrounded by a loop including the first Josephson junction 21, the second Josephson junction 22, and the third Josephson junction 23 may be controlled. By controlling the magnetic flux, the strength of the coupling between the first qubit 50A and the second qubit 50B may be changed. The first circuit 10C may function as a variable coupling coupler.

As shown in FIG. 1, the first end 21a and the second end 22a may be set to one potential (e.g., the potential of ground GND). A first capacitor C1 may be formed between the first end 21a and the second end 22a. The first capacitor C1 is connected in parallel with the first Josephson junction 21.

As shown in FIG. 1, the first qubit 50A may include a fourth Josephson junction 24. The first qubit 50A may include a sixth capacitor C6. The sixth capacitor C6 is connected in parallel with the fourth Josephson junction 24.

The first structure 51 may include a first qubit conductive portion 50Ac connected with the first qubit 50A. The first qubit conductive portion 50Ac is configured to be coupled with the first circuit portion 10a (i.e., the first conductive member 11a). For example, a fourth capacitor C4 is formed between the first qubit conductive portion 50Ac and the first circuit portion 10a (the first conductive member 11a).

As shown in FIG. 1, the second qubit 50B may include a fifth Josephson junction 25. The second qubit 50B may include a seventh capacitor C7. The seventh capacitor C7 is connected in parallel with the fifth Josephson junction 25.

The second structure 52 may include a second qubit conductive portion 50Bc connected with the second qubit 50B. The second qubit conductive portion 50Bc is configured to be coupled with the second conductive member 11b. A fifth capacitor C5 may be formed between the second qubit conductive portion 50Bc and the second conductive member 11b.

As shown in FIG. 1, a second capacitor C2 may be formed between the second conductive member 11b and the ground GND.

As shown in FIG. 1, the first structure 51 may further include a fourth conductive member 11d. The fourth conductive member 11d is configured to be coupled with the first circuit portion 10a. The third structure 53 may further include a fifth conductive member 11e. A part of the fifth conductive member 11e is configured to be coupled with the fourth conductive member 11d. The other part of the fifth conductive member 11e is configured to be coupled with the third conductive member 11c.

For example, a part of the fifth conductive member 11e may be configured to be coupled with the fourth conductive member 11d via the third connecting member 15c. A third capacitor C3 may be formed between the fifth conductive member 11e and the third conductive member 11c.

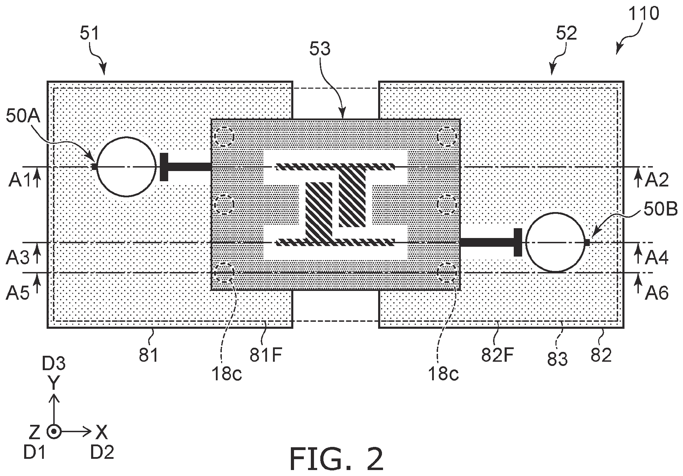

FIG. 2 is a schematic plan view illustrating the computing device according to the first embodiment.

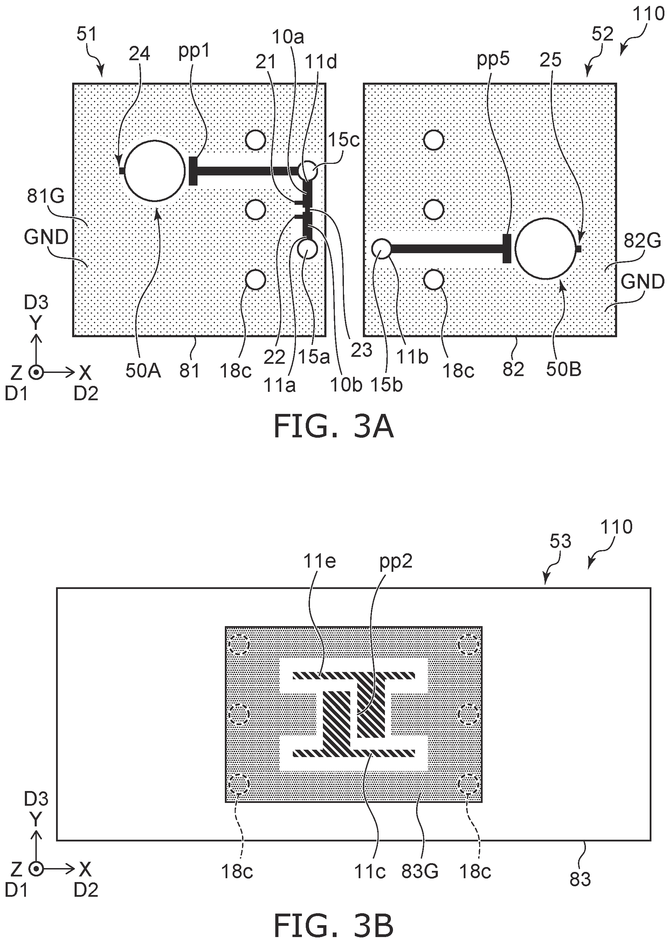

FIGS. 3A and 3B are schematic plan views illustrating the computing device according to the first embodiment.

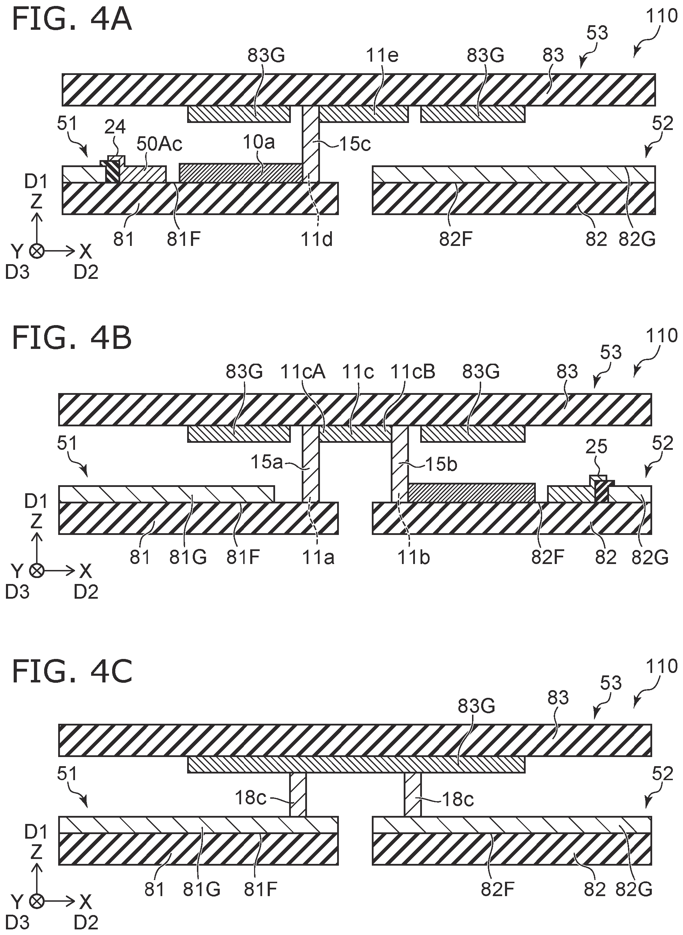

FIGS. 4A to 4C are schematic cross-sectional views illustrating the computing device according to the first embodiment.

FIG. 3A illustrates the first structure 51 and the second structure 52. FIG. 3B illustrates the third structure 53. FIG. 4A is a cross-sectional view taken along the line A1-A2 in FIG. 2. FIG. 4B is a cross-sectional view taken along the line A3-A4 in FIG. 2. FIG. 4C is a cross-sectional view taken along the line A5-A6 in FIG. 2.

As shown in FIGD. 4A to 4C, the first base 81 includes a first face 81F. A first direction D1 crossing the first face 81F is defined as a Z-axis direction. One direction perpendicular to the Z-axis direction is defined as an X-axis direction. A direction perpendicular to the Z-axis direction and the X-axis direction is defined as a Y-axis direction. The first face 81F is, for example, along the X-Y plane.

The second base 82 includes a second face 82F. The second face 82F crosses the first direction D1. The second face 82F is along, for example, the X-Y plane. A second direction D2 from the first base 81 to the second base 82 crosses the first direction D1. The second direction D2 may be, for example, the X-axis direction.

A part of the third base 83 overlaps the first base 81 in the first direction D1. Another part of the third base 83 overlaps the second base 82 in the first direction D1.

In this example, the computing device 110 includes a first connecting member 15a and a second connecting member 15b. The first connecting member 15a is configured to couple the first conductive portion 11cA to the first conductive member 11a. The second connecting member 15b is configured to couple the second conductive portion 11cB to the second conductive member 11b. For example, the first connecting member 15a electrically connects the first conductive portion 11cA to the first conductive member 11a. For example, the second connecting member 15b electrically connects the second conductive portion 11cB to the second conductive member 11b.

At least a part of the first connecting member 15a is located between the first base 81 and the third base 83 in the first direction D1. At least a part of the second connecting member 15b is located between the second base 82 and the third base 83 in the first direction D1.

The computing device 110 may include a third connecting member 15c. The third connecting member 15c is configured to couple the fourth conductive member 11d to the fifth conductive member 11e. For example, the third connecting member 15c electrically connects the fourth conductive member 11d to the fifth conductive member 11e. At least a part of the third connecting member 15c is located between the first base 81 and the third base 83 in the first direction D1.

As shown in FIG. 4B, at least a part of the third conductive member 11c is located between the first base 81 and the third base 83. As shown in FIG. 4A, at least a part of the fifth conductive member 11e is located between the first base 81 and the third base 83.

As shown in FIG. 3A, the position of the first qubit 50A in the third direction D3 may be different from the position of the second qubit 50B in the third direction D3. The third direction D3 crosses a plane including the first direction D1 and the second direction D2. The third direction D3 may be, for example, the Y-axis direction.

As shown in FIG. 3A, the first structure 51 may include a first base conductive layer 81G. The second structure 52 may include a second base conductive layer 82G. As shown in FIG. 3B, the third structure 53 may include a third base conductive layer 83G. These base conductive layers correspond to the ground GND.

As shown in FIG. 4C, the first base conductive layer 81G may be electrically connected with the third base conductive layer 83G by an interlayer connecting member 18c. The second base conductive layer 82G may be electrically connected with the third base conductive layer 83G by another interlayer connecting member 18c.

As already explained, the first structure 51 may include a first qubit conductive portion 50Ac (see FIG. 1). The first qubit conductive portion 50Ac is connected with the first qubit 50A. The first circuit portion 10a includes a first portion pp1 facing the first qubit conductive portion 50Ac. The other part of the fifth conductive member 11e includes a second portion pp2 facing the third conductive member 11c.

In the embodiment, for example, a second capacitance Cp2 between the second portion pp2 and the third conductive member 11c is larger than a first capacitance Cp1 between the first portion pp1 and the first qubit conductive portion 50Ac. The second capacitance Cp2 is the capacitance of the third capacitor C3. The first capacitance Cp1 is the capacitance of the fourth capacitor C4. The above capacitance relationship makes it easy to obtain desired operation. In one example, even when the magnetic flux passing through the space 10S is close to zero, a sufficiently small residual ZZ coupling strength is obtained. For example, the residual ZZ coupling strength can be suppressed to 10 kHz or less.

For example, a second area of the part of the second portion pp2 facing the third conductive member 11c may be larger than a first area of the part of the first portion pp1 facing the first qubit conductive portion 50Ac.

As shown in FIG. 1, the second conductive member 11b includes a fifth portion pp5 facing the second qubit conductive portion 50Bc. A fifth capacitor C5 is formed between the second qubit conductive portion 50Bc and the fifth portion pp5. For example, the second capacitance Cp2 may be larger than a fifth capacitance Cp5 (the capacitance of the fifth capacitor C5) between the fifth portion pp5 and the second qubit conductive portion 50Bc. The above capacitance relationship makes it easy to obtain the desired operation. In one example, even when the magnetic flux passing through the space 10S is close to zero, a sufficiently small residual ZZ coupling strength is obtained. For example, the residual ZZ coupling strength can be suppressed to 10 kHz or less.

For example, the second area of the part of the second portion pp2 facing the third conductive member 11c may be larger than a third area of the part of the fifth portion pp5 facing the second qubit conductive portion 50Bc.

In the embodiment, the third conductive member 11c is fixed to the third base 83. The first qubit 50A is provided on the first base 81, and the second qubit 50B is provided on the second base 82. The area of a practical coupler can be reduced. This makes it easy to obtain a highly integrated computing device.

As shown in FIG. 1, the computing device 110 may further include a controller 70. The controller 70 is configured to control the magnetic flux passing through the space 10S surrounded by the loop including the first Josephson junction 21, the second Josephson junction 22, and the third Josephson junction 23. As shown in FIG. 1, the computing device 110 may include a control conductive portion 61. The controller 70 is configured to supply, for example, a signal including an AC component to the control conductive portion 61. The magnetic flux is controlled by the signal including the AC component.

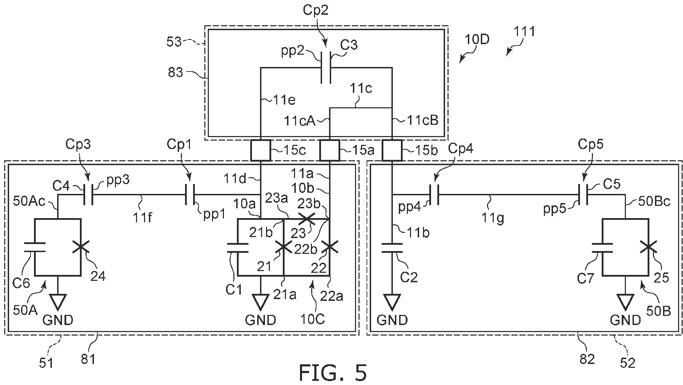

FIG. 5 is a schematic diagram illustrating a computing device according to the first embodiment.

As shown in FIG. 5, in a computing device 111 according to the embodiment, the first structure 51 includes a sixth conductive member 11f. The configuration of the computing device 111 except for this may be the same the configuration of the computing device 110.

In the computing device 111, the sixth conductive member 11f is configured to be coupled with the first qubit 50A and the first circuit portion 10a. In this example, the first circuit portion 10a is coupled with the first qubit 50A via the sixth conductive member 11f.

In this example, the second structure 52 further includes a seventh conductive member 11g. The seventh conductive member 11g is configured to be coupled with the second qubit 50B and the second conductive member 11b. The second conductive member 11b is coupled with the second qubit 50B via the seventh conductive member 11g. In the computing device 111, high performance is easily obtained stably. A high manufacturing yield is easily obtained. For example, a large-scale quantum computer can be easily obtained. A computing device capable of obtaining stable characteristics can be provided.

In the computing device 111, the first circuit portion 10a includes the first portion pp1 facing the sixth conductive member 11f. The other part of the fifth conductive member 11e includes the second portion pp2 facing the third conductive member 11c. For example, the second capacitance Cp2 between the second portion pp2 and the third conductive member 11c may be greater than the first capacitance Cp1 between the first portion pp1 and the sixth conductive member 11f.

In the computing device 111, the first structure 51 includes the first qubit conductive portion 50Ac connected with the first qubit 50A. The sixth conductive member 11f includes the third portion pp3 facing the first qubit conductive portion 50Ac. For example, the second capacitance Cp2 may be larger than the third capacitance Cp3 between the third portion pp3 and the first qubit 50A. The third capacitance Cp3 corresponds to the capacitance of the fourth capacitor C4.

The second conductive member 11b includes a fourth portion pp4 facing the seventh conductive member 11g. The second capacitance Cp2 between the second portion pp2 and the third conductive member 11c may be larger than a fourth capacitance Cp4 between the fourth portion pp4 and the seventh conductive member 11g. The fourth capacitance Cp4 corresponds to the capacitance of the fourth capacitor C4.

The second structure 52 includes the second qubit conductive portion 50Bc connected with the second qubit 50B. The seventh conductive member 11g includes the fifth portion pp5 facing the second qubit conductive portion 50Bc. The second capacitance Cp2 is greater than a fifth capacitance Cp5 between the fifth portion pp5 and the second qubit conductive portion 50Bc. The fifth capacitance Cp5 corresponds to the capacitance of the fifth capacitor C5.

At least one of the first connecting member 15a, the second connecting member 15b, or the third connecting member 15c may include a metal. These connecting members may include, for example, at least one selected from the group consisting of In, Cu, Nb, Au, Sn, Pb, and Cr.

The computing device 111 may also be provided with the controller 70 and the control conductive portion 61 (see FIG. 1). In FIG. 5, the controller 70 and the control conductive portion 61 are omitted.

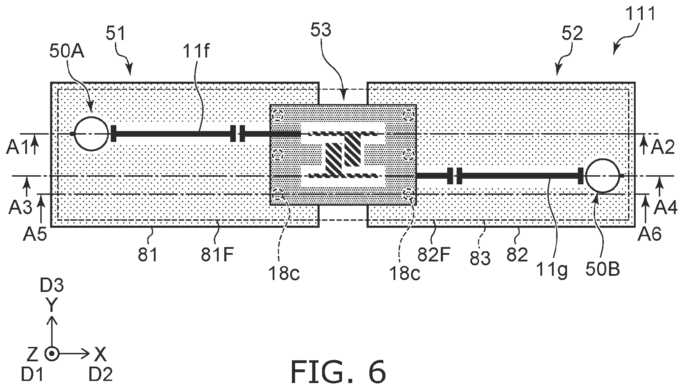

FIG. 6 is a schematic plan view illustrating a computing device according to the first embodiment.

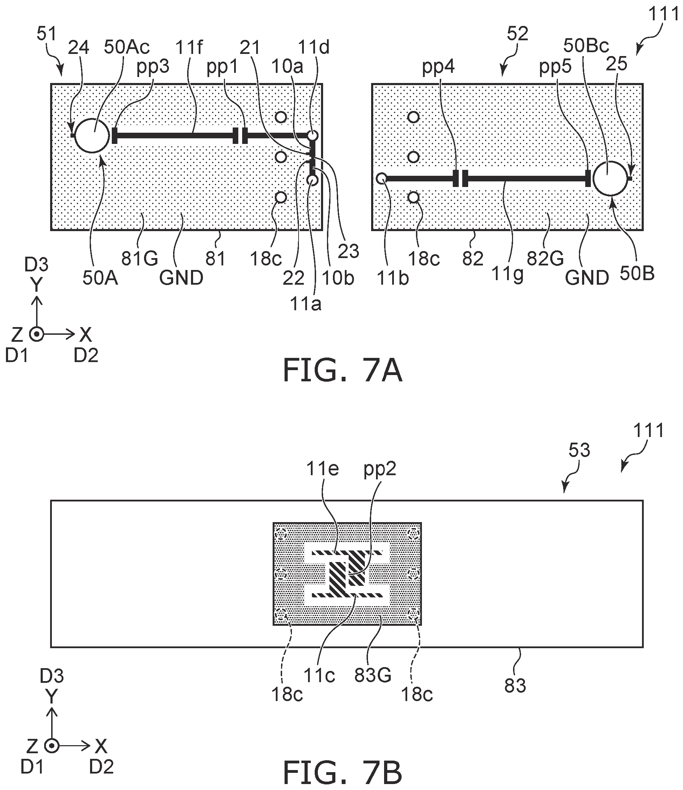

FIGS. 7A and 7B are schematic plan views illustrating the computing device according to the first embodiment.

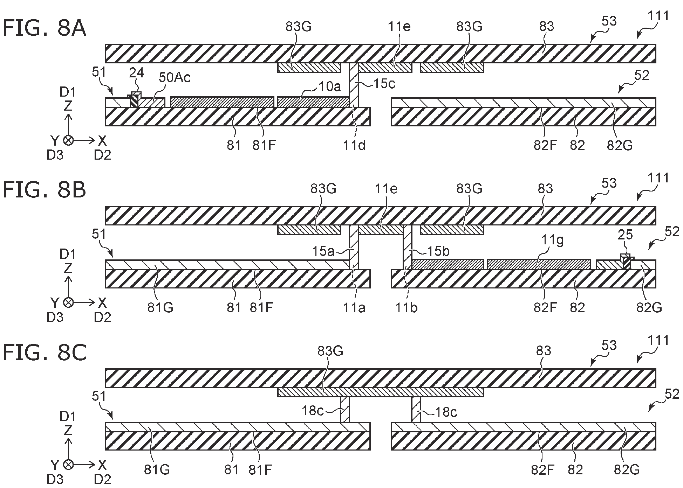

FIGS. 8A to 8C are schematic cross-sectional views illustrating the computing device according to the first embodiment.

FIG. 7A illustrates the first structure 51 and the second structure 52. FIG. 7B illustrates the third structure 53. FIG. 8A is a cross-sectional view taken along the line A1-A2 in FIG. 6. FIG. 8B is a cross-sectional view taken along the line A3-A4 in FIG. 6. FIG. 8C is a cross-sectional view taken along the line A5-A6 in FIG. 6.

The first base 81 includes the first face 81F. The first face 81F crosses the first direction D1. The second base 82 includes the second face 82F. The second face 82F crosses the first direction D1. A part of the third base 83 overlaps the first base 81 in the first direction D1. Another part of the third base 83 overlaps the second base 82 in the first direction D1.

For example, the first connecting member 15a electrically connects the first conductive portion 11cA to the first conductive member 11a. The second connecting member 15b electrically connects the second conductive portion 11cB to the second conductive member 11b. The third connecting member 15c electrically connects the fourth conductive member 11d to the fifth conductive member 11e. At least a part of the first connecting member 15a is located between the first base 81 and the third base 83 in the first direction D1. At least a part of the second connecting member 15b is located between the second base 82 and the third base 83 in the first direction D1. At least a part of the third connecting member 15c is located between the first base 81 and the third base 83 in the first direction D1.

As shown in FIG. 8B, at least a part of the third conductive member 11c is located between the first base 81 and the third base 83. As shown in FIG. 8A, at least a part of the fifth conductive member 11e is located between the first base 81 and the third base 83.

### (Second Embodiment)

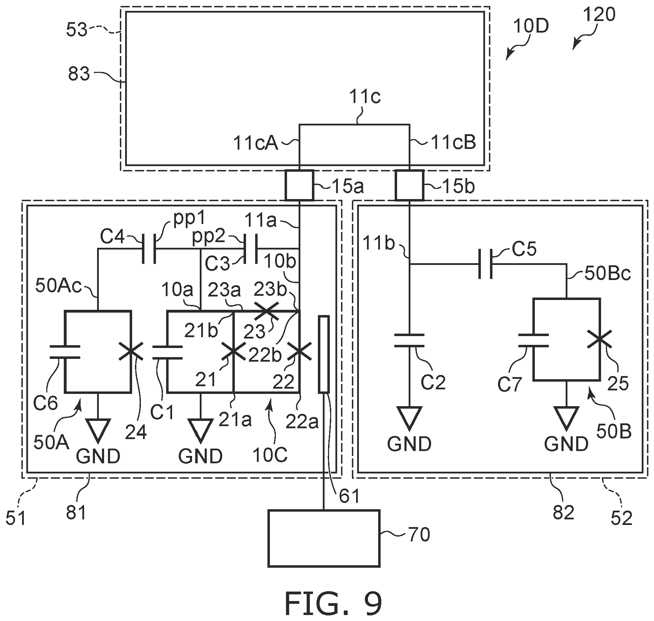

FIG. 9 is a schematic diagram illustrating a computing device according to the second embodiment.

As shown in FIG. 9, in a computing device 120 according to the embodiment, the third capacitor C3 is provided in the first structure 51. The configuration of the computing device 120 except for this may be the same as the configuration of the computing device 110.

In the computing device 120, the first structure 51 includes the first circuit portion 10a and the first other circuit portion 10b. The first circuit portion 10a is configured to be capacitively coupled with the first other circuit portion 10b. The first circuit portion 10a and the first other circuit portion 10b form the third capacitor C3.

It is easy to obtain high performance stably in the computing device 120 as well. It is easy to obtain a high manufacturing yield. It is possible to provide a computing device that can obtain stable characteristics.

The first structure 51 includes the first qubit conductive portion 50Ac connected with the first qubit 50A. The first circuit portion 10a includes the first portion pp1 facing the first qubit conductive portion 50Ac. The first circuit portion 10a includes the second portion pp2 facing the first other circuit portion 10b. The second capacitance Cp2 between the second portion pp2 and the first other circuit portion 10b may be larger than the first capacitance Cp1 between the first portion pp1 and the first qubit conductive portion 50Ac. The second capacitance Cp2 corresponds to the capacitance of the third capacitor C3. The first capacitance Cp1 corresponds to the capacitance of the fourth capacitor C4.

### (Third Embodiment)

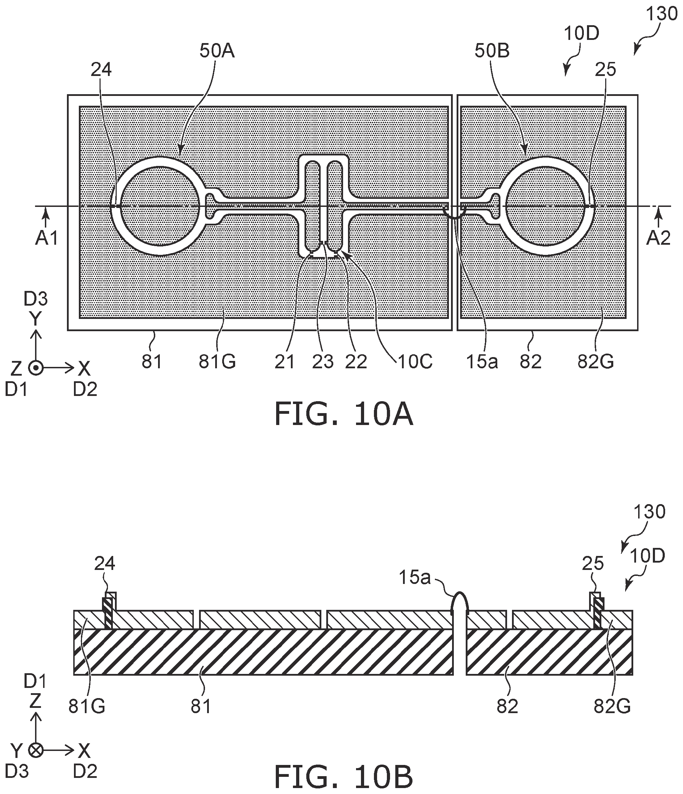

FIGS. 10A and 10B are schematic views illustrating a computing device according to a third embodiment.

FIG. 10B is a cross-sectional view taken along the line A1-A2 in FIG. 10A.

As shown in FIGS. 10A and 10B, a computing device 130 according to the embodiment includes the first base 81 and the second base 82, and does not include the third base 83. The configuration of the computing device 130 except for this may be the same as the configuration of the computing device 110.

In computing device 130, the first qubit 50A and the first circuit 10C are provided on the first base 81. The second qubit 50B is provided on the second base 82. The first circuit 10C is coupled with the second qubit 50B via the first connecting member 15a.

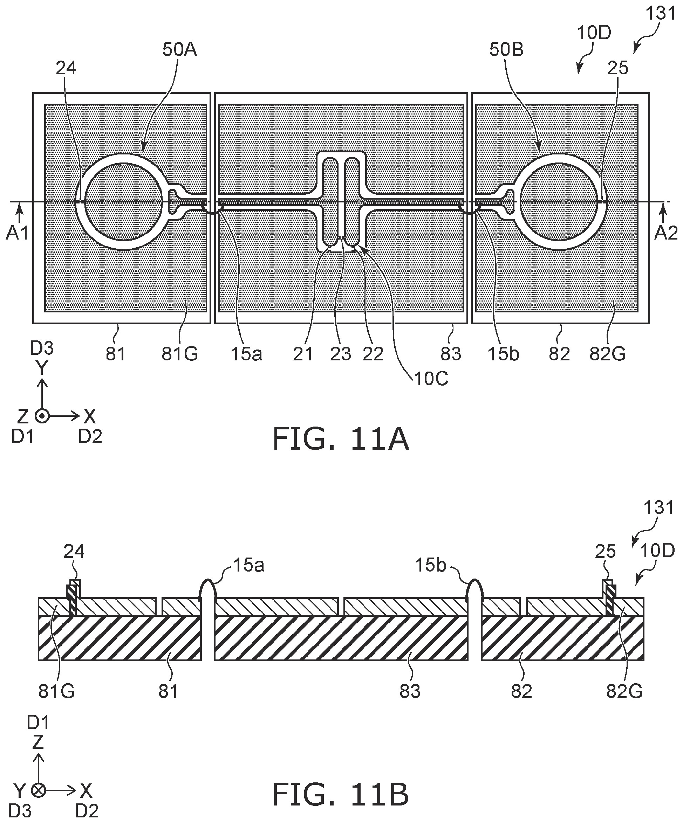

FIGS. 11A and 11B are schematic views illustrating a computing device according to the third embodiment.

FIG. 11B is a cross-sectional view taken along the line A1-A2 in FIG. 11A.

As shown in FIGS. 11A and 11B, in a computing device 131 according to the embodiment, the first circuit 10C is provided on the third base 83. The configuration of computing device 131 except for this may be the same as the configuration of the computing device 130.

In the computing device 131, the first qubit 50A is provided on the first base 81. The second qubit 50B is provided on the second base 82. The first circuit 10C is coupled with the first qubit 50A via the first connecting member 15a. The first circuit 10C is coupled with the second qubit 50B via the second connecting member 15b.

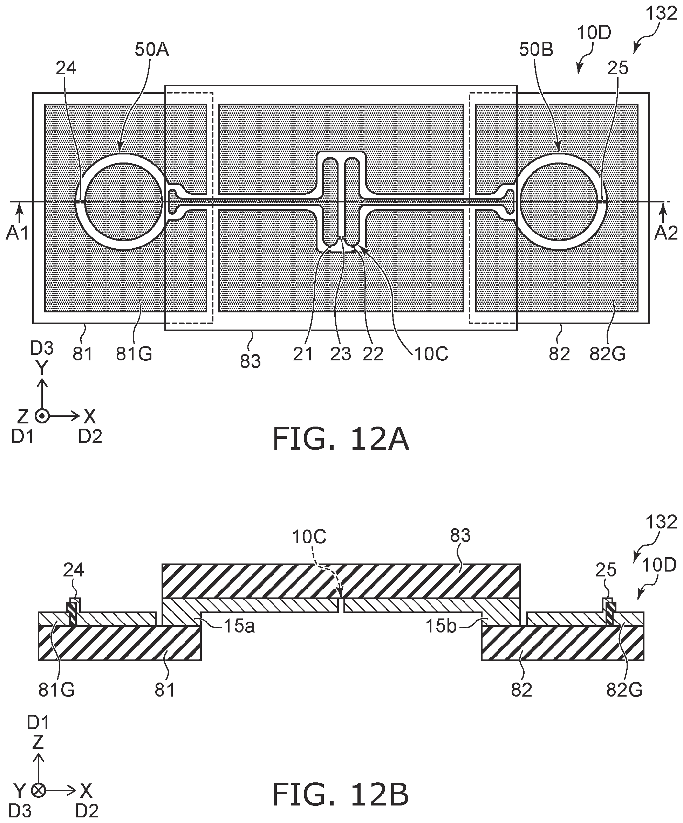

FIGS. 12A and 12B are schematic views illustrating a computing device according to the third embodiment.

FIG. 12B is a cross-sectional view taken along the line A1-A2 in FIG. 12A.

As shown in FIGS. 12A and 12B, in a computing device 132 according to the embodiment, the third base 83 overlaps the first base 81 and overlaps the second base 82. The configuration of the computing device 132 except for this may be the same as the configuration of the computing device 131.

In the computing device 132, the position in the first direction D1 of the conductive member included in the third base 83 is between the position in the first direction D1 of the first base 81 and the position in the first direction D1 of the third base 83. The position of the conductive member included in the third base 83 in the first direction D1 is between the position of the second base 82 in the first direction D1 and the position of the third base 83 in the first direction D1.

In the computing device 132, the first circuit 10C is coupled with the first qubit 50A provided on the first base 81 via the first connecting member 15a. The first circuit 10C is coupled with the second qubit 50B provided on the second base 82 via the second connecting member 15b.

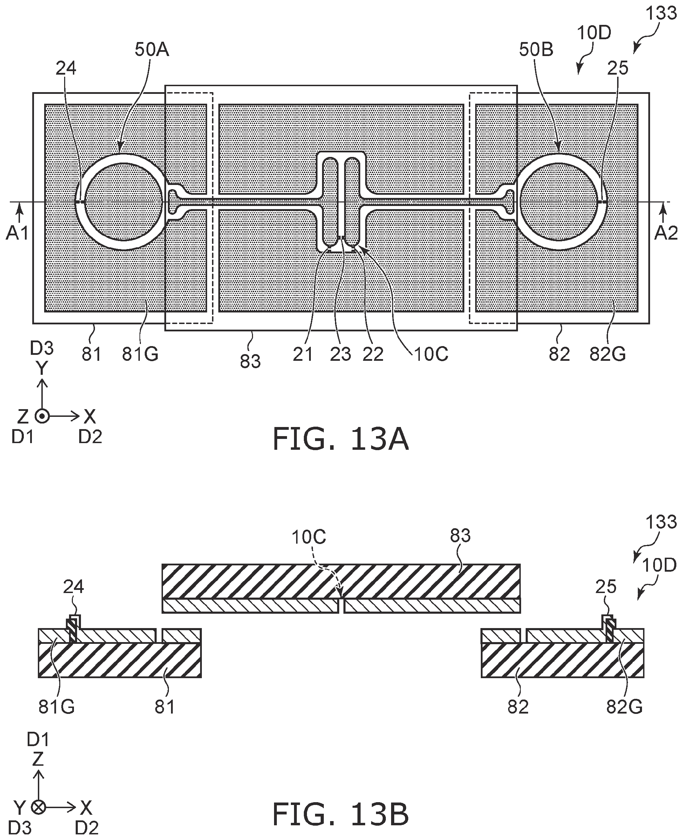

FIGS. 13A and 13B are schematic views illustrating a computing device according to the third embodiment.

FIG. 13B is a cross-sectional view taken along the line A1-A2 in FIG. 13A.

As shown in FIGS. 13A and 13B, in a computing device 133 according to the embodiment, the connecting members are omitted from the configuration of the computing device 132. The configuration of the computing device 133 except for this may be the same as the configuration of the computing device 132.

In the computing device 133, the first circuit 10C provided on the third base 83 is coupled with the first qubit 50A provided on the first base 81. The first circuit 10C provided on the third base 83 is coupled with the second qubit 50B provided on the second base 82. The coupling may be, for example, capacitive coupling.

Below, examples of characteristics of the computing devices related to the first to third embodiments described above are described.

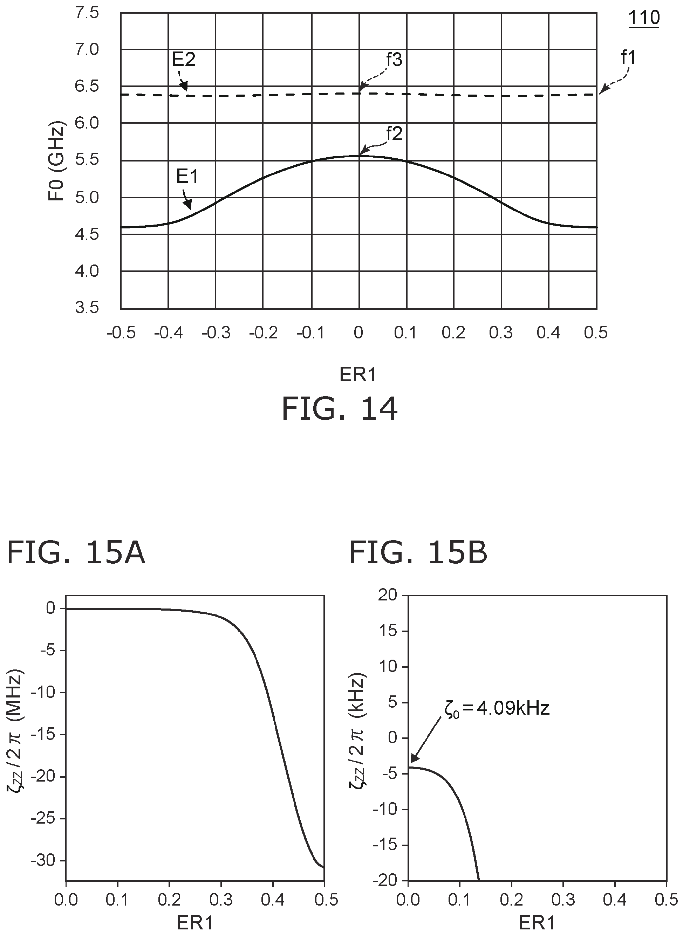

FIG. 14 is a schematic diagram illustrating the characteristics of a computing device according to the embodiment.

As already explained, magnetic flux passes through the space 10S surrounded by the loop including the first Josephson junction 21, the second Josephson junction 22, and the third Josephson junction 23. The horizontal axis of FIG. 14 is a magnetic flux ratio ER1. The magnetic flux ratio ER1 is a ratio of the magnetic flux passing through the space 10S to a magnetic flux quantum. The vertical axis of FIG. 14 is frequency F0. The frequency F0 corresponds to the energy level of the excited state.

As shown in FIG. 14, the first circuit 10C has a plurality of excited states. The plurality of excited states include a first excited state E1 and a second excited state E2. The excited states are controllable by magnetic flux.

As shown in FIG. 14, the first circuit 10C has a first frequency f1, a second frequency f2, and a third frequency f3. The second frequency f2 corresponds to an energy level of the first excited state E1 of the first circuit 10C when the magnetic flux passing through the space 10S surrounded by the loop is zero. The third frequency f3 corresponds to an energy level of the second excited state E2 of the first circuit 10C when the magnetic flux is zero. The first frequency f1 corresponds to an energy level of the second excited state E2 when the magnetic flux is 0.5 times the magnetic flux quantum (when the magnetic flux ratio ER1 is 0.5).

As shown in FIG. 14, for example, 1/2 of the sum of the second frequency f2 and the third frequency f3 is smaller than the first frequency f1. 1/2 of the sum of the second frequency f2 and the third frequency f3 corresponds to an average of the second frequency f2 and the third frequency f3.

In the embodiment, a sufficiently small residual ZZ coupling strength is obtained even when the magnetic flux is close to zero. For example, the residual ZZ coupling strength can be suppressed to 10 kHz or less. This makes it possible to control the ZZ coupling strength, for example, by an AC signal with substantially zero DC component. This AC signal may be supplied by the control conductive portion 61.

For example, it is possible to execute a two-qubit gate operation using a signal that does not include a DC component. The two-qubit gate operation corresponds to a CZ gate. For example, the effects of noise such as heat from the outside can be suppressed. This enables highly accurate control. According to the embodiment, it is possible to provide a computing device whose characteristics can be improved.

The characteristics described with reference to FIG. 14 may be applied to the computing devices described with reference to the first to third embodiments and their modifications.

For example, the difference between the first frequency f1 and 1/2 of the sum of the second frequency f2 and the third frequency f3 is taken as the frequency difference Δf. The frequency difference Δf is {(f2+f3)/2}-f1. In the embodiment, the frequency difference Δf is negative.

The characteristics illustrated in FIG. 14 can be obtained, for example, by optimizing the configuration of the computing device 110. As already explained, the first capacitor C1, the second capacitor C2, and the third capacitor C3 are formed.

In the embodiment, for example, the capacitance of the third capacitor C3 is greater than 0.2 times the capacitance of the first capacitor C1. For example, the capacitance of the third capacitor C3 is greater than 0.2 times the capacitance of the second capacitor C2. This makes it easier for the frequency difference Δf to become negative.

In the embodiment, the first frequency f1 may be, for example, not less than 1 GHz and not more than 20 GHz. The second frequency f2 may be, for example, not less than 1 GHz and not more than 20 GHz. For example, the third frequency f3 may be, for example, not less than 1 GHz and not more than 20 GHz.

FIGS. 15A and 15B are graphs illustrating the characteristics of the electronic circuit according to the embodiment.

The horizontal axis of these figures is the magnetic flux ratio ER1. The magnetic flux ratio ER1 is the ratio of the magnetic flux Φ to the magnetic flux quantum Φ0. The vertical axis is the ZZ coupling strength ζzz. FIG. 15B shows an enlarged view of a part of FIG. 15A. As shown in FIG. 15A and 15B, at a low magnetic flux ratio ER1, a sufficiently small ZZ coupling strength ζzz is obtained. At a low magnetic flux ratio ER1, it is possible to operate the coupled qubit. As shown in FIG. 15A and 15B, the ZZ coupling strength ζzz when the magnetic flux ratio ER1 is zero (magnetic flux Φ is zero) is taken as the residual ZZ coupling strength ζ0. In this example, the absolute value of the residual ZZ coupling strength ζ0/2π is 4.09 kHz, which is less than 5 kHz. "π" is circle ratio.

The embodiment may include the following Technical proposals:
(Technical proposal 1)
   A computing device, comprising:
   an element part including:
      a first structure;
      a second structure; and,
      a third structure,
   the first structure including:
      a first base;
      a first qubit fixed to the first base;
      a first circuit fixed to the first base and including a first Josephson junction, the first circuit including a first circuit portion and a first other circuit portion, the first circuit portion being configured to be coupled with the first qubit; and
      a first conductive member electrically connected with the first other circuit portion,
   the second structure including:
      a second base;
      a second qubit fixed to the second base; and
      a second conductive member fixed to the first base and configured to be coupled with the second qubit, and
   a third structure including:
      a third base; and
      a third conductive member fixed to the third base, the third conductive member including a first conductive portion and a second conductive portion, the first conductive portion being configured to be coupled with the first conductive member, the second conductive portion being configured to be coupled with the second conductive member.
(Technical proposal 2)
   The computing device according to Technical proposal 1, wherein
   the first circuit further includes:
      a second Josephson junction fixed to the first base, and
      a third Josephson junction fixed to the first base,
      the first Josephson junction includes a first end and a first other end,
      the first other end corresponds to the first circuit portion,
      the second Josephson junction includes a second end and a second other end,
      the second other end corresponds to the first other circuit portion,
      the second end is electrically connected with the first end,
      the third Josephson junction includes a third end and a third other end,
      the third end is electrically connected with the first other end, and
      the third other end is electrically connected with the second other end.
(Technical proposal 3)
   The computing device according to Technical proposal 1 or 2, wherein
   the first circuit includes a variable coupling coupler.
(Technical proposal 4)
   The computing device according to any one of Technical proposals 1-3, wherein
   the first base includes a first face,
   a part of the third base overlaps the first base in a first direction crossing the first face, and
   another part of the third base overlaps the second base in the first direction.
(Technical proposal 5)
   The computing device according to Technical proposal 4, further comprising:
   a first connecting member; and
   a second connecting member,
   the first connecting member being configured to couple the first conductive portion to the first conductive member, and
   the second connecting member being configured to couple the second conductive portion to the second conductive member.
(Technical proposal 6)
   The computing device according to Technical proposal 5, wherein
   at least a part of the first connecting member is between the first base and the third base in the first direction, and
   at least a part of the second connecting member is between the second base and the third base in the first direction.
(Technical proposal 7)
   The computing device according to any one of Technical proposals 1-6, wherein
   The first structure further includes a fourth conductive member,
   the fourth conductive member is configured to be coupled with the first circuit portion,
   the third structure further includes a fifth conductive member,
   a part of the fifth conductive member is configured to be coupled with the fourth conductive member, and
   another part of the fifth conductive member is configured to be coupled with the third conductive member.
(Technical proposal 8)
   The computing device according to Technical proposal 7, further comprising:
   a third connecting member,
   the third connecting member being configured to couple the fourth conductive member to the fifth conductive member.
(Technical proposal 9)
   The computing device according to Technical proposal 7 or 8, wherein
   The first structure further includes a first qubit conductive portion connected with the first qubit,
   the first circuit portion includes a first portion facing the first qubit conductive portion,
   the other part of the fifth conductive member includes a second portion facing the third conductive member, and
   a second capacitance between the second portion and the third conductive member is greater than a first capacitance between the first portion and the first qubit conductive portion.
(Technical proposal 10)
   The computing device according to Technical proposal 7, wherein
   the first structure further includes a sixth conductive member,
   the sixth conductive member is configured to be coupled with the first qubit and the first circuit portion.
(Technical proposal 11)
   The computing device according to Technical proposal 10, wherein
   the first circuit portion includes a first portion facing the sixth conductive member,
   the other part of the fifth conductive member includes a second portion facing the third conductive member, and
   a second capacitance between the second portion and the third conductive member is greater than a first capacitance between the first portion and the sixth conductive member.
(Technical proposal 12)
   The computing device according to Technical proposal 11, wherein
   the first structure further includes a first qubit conductive portion connected with the first qubit,
   the sixth conductive member includes a third portion facing the first qubit conductive portion, and
   the second capacitance is greater than a third capacitance between the third portion and the first qubit.
(Technical proposal 13)
   The computing device according to Technical proposal 12, wherein
   the second structure further includes a seventh conductive member,
   the seventh conductive member is configured to be coupled with the second qubit and the second conductive member.
(Technical proposal 14)
   The computing device according to Technical proposal 13, wherein
   the second conductive member includes a fourth portion facing the seventh conductive member, and
   the second capacitance is greater than a fourth capacitance between the fourth portion and the seventh conductive member.
(Technical proposal 15)
   The computing device according to Technical proposal 14, wherein
   the second structure further includes a second qubit conductive portion connected with the second qubit,
   the seventh conductive member includes a fifth portion facing the second qubit conductive portion, and
   the second capacitance is greater than a fifth capacitance between the fifth portion and the second qubit conductive portion.
(Technical proposal 16)
   The computing device according to any one of Technical proposals 1-5, wherein
   the first circuit portion is configured to be capacitively coupled with the first other circuit portion.
(Technical proposal 17)
   The computing device according to Technical proposal 16, wherein
   the first structure further includes a first qubit conductive portion connected with the first qubit,
   the first circuit portion includes a first portion facing the first qubit conductive portion,
   the first circuit portion includes a second portion facing the first other circuit portion, and
   a second capacitance between the second portion and the first other circuit portion is greater than a first capacitance between the first portion and the first qubit conductive portion.
(Technical proposal 18)
   The computing device according to Technical proposal 2, wherein
   1/2 of a sum of a second frequency and a third frequency in the first circuit is smaller than a first frequency,
   the second frequency corresponds to a first excited state of the first circuit when a magnetic flux passing through a space surrounded by a loop including the first Josephson junction, the second Josephson junction, and the third Josephson junction is zero,
   the third frequency corresponds to a second excited state of the first circuit when the magnetic flux is zero,
   the first frequency corresponds to the second excited state when the magnetic flux is 0.5 times a magnetic flux quantum.
(Technical proposal 19)
   The computing device according to Technical proposal 18, wherein
   the first frequency is not less than 1 GHz and not more than 20 GHz.
(Technical proposal 20)
   The computing device according to Technical proposal 18 or 19, further comprising:
   a controller,
   the controller being configured to control the magnetic flux.

According to the embodiment, a computing device capable of obtaining stable characteristics can be provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in computing devices, structures, Josephson junctions, bases, conductive members, controllers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all computing devices practicable by an appropriate design modification by one skilled in the art based on the computing devices described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

### [Reference Numeral List]

10C: first circuit, 10D: element portion, 10S: space, 10a: first circuit portion, 10b: first other circuit portion, 11a to 11g: first to seventh conductive members, 15a to 15c: first to third connecting members, 18c: interlayer connecting member, 21 to 25: first to fifth Josephson junctions, 21a to 23a: first to third ends, 21b to 23b: first to third other ends, 50A, 50B: first and second qubits, 50Ac, 50Bc: first and second qubit conductive portions, 51 to 53: first to third structures, 61: control conductive portion, 70: controller, 81 to 83: first to third bases, 81F, 82F: first and second faces, 81G to 83G: first to third base conductive layers, 110, 111, 120, 130 to 133: computing device, C1 to C7: first to seventh capacitors, Cp1 to Cp5: first to fifth capacitances, D1 to D3: first to third directions, E1, E2: first and second excited states, ER1: magnetic flux ratio, F0: frequency, GND: ground, f1 to f3: first to third frequencies, pp1 to pp5: first to fifth portions

## Claims

1. A computing device, comprising:
an element part including:
a first structure;
a second structure; and,
a third structure,
the first structure including:
a first base;
a first qubit fixed to the first base;
a first circuit fixed to the first base and including a first Josephson junction, the first circuit including a first circuit portion and a first other circuit portion, the first circuit portion being configured to be coupled with the first qubit; and
a first conductive member electrically connected with the first other circuit portion,
the second structure including:
a second base;
a second qubit fixed to the second base; and
a second conductive member fixed to the first base and configured to be coupled with the second qubit, and
a third structure including:
a third base; and
a third conductive member fixed to the third base, the third conductive member including a first conductive portion and a second conductive portion, the first conductive portion being configured to be coupled with the first conductive member, the second conductive portion being configured to be coupled with the second conductive member.

2. The computing device according to claim 1, wherein
the first circuit further includes:
a second Josephson junction fixed to the first base, and
a third Josephson junction fixed to the first base,
the first Josephson junction includes a first end and a first other end,
the first other end corresponds to the first circuit portion,
the second Josephson junction includes a second end and a second other end,
the second other end corresponds to the first other circuit portion,
the second end is electrically connected with the first end,
the third Josephson junction includes a third end and a third other end,
the third end is electrically connected with the first other end, and
the third other end is electrically connected with the second other end.

3. The computing device according to claim 1 or 2, wherein
the first base includes a first face,
a part of the third base overlaps the first base in a first direction crossing the first face, and
another part of the third base overlaps the second base in the first direction.

4. The computing device according to claim 3, further comprising:
a first connecting member; and
a second connecting member,
the first connecting member being configured to couple the first conductive portion to the first conductive member, and
the second connecting member being configured to couple the second conductive portion to the second conductive member.

5. The computing device according to claim 1 or 2, wherein
the first structure further includes a fourth conductive member,
the fourth conductive member is configured to be coupled with the first circuit portion,
the third structure further includes a fifth conductive member,
a part of the fifth conductive member is configured to be coupled with the fourth conductive member, and
another part of the fifth conductive member is configured to be coupled with the third conductive member.

6. The computing device according to claim 5, further comprising:
a third connecting member,
the third connecting member being configured to couple the fourth conductive member to the fifth conductive member.

7. The computing device according to claim 5, wherein
the first structure further includes a sixth conductive member,
the sixth conductive member is configured to be coupled with the first qubit and the first circuit portion.

8. The computing device according to claim 7, wherein
the first circuit portion includes a first portion facing the sixth conductive member,
the other part of the fifth conductive member includes a second portion facing the third conductive member,
a second capacitance between the second portion and the third conductive member is greater than a first capacitance between the first portion and the sixth conductive member,
the first structure further includes a first qubit conductive portion connected with the first qubit,
the sixth conductive member includes a third portion facing the first qubit conductive portion, and
the second capacitance is greater than a third capacitance between the third portion and the first qubit.

9. The computing device according to claim 8, wherein
the second structure further includes a seventh conductive member,
the seventh conductive member is configured to be coupled with the second qubit and the second conductive member.

10. The computing device according to claim 2, wherein
1/2 of a sum of a second frequency and a third frequency in the first circuit is smaller than a first frequency,
the second frequency corresponds to a first excited state of the first circuit when a magnetic flux passing through a space surrounded by a loop including the first Josephson junction, the second Josephson junction, and the third Josephson junction is zero,
the third frequency corresponds to a second excited state of the first circuit when the magnetic flux is zero,
the first frequency corresponds to the second excited state when the magnetic flux is 0.5 times a magnetic flux quantum.
